# EUROPÄISCHE PATENTSCHRIFT

(11) **EP 2 394 497 B1**
(45) Veröffentlichungstag und Bekanntmachung des Hinweises auf die Patenterteilung: **22.03.2017**
(21) Anmeldenummer: 10701220.5
(22) Anmeldetag: 15.01.2010
(51) Int. Cl.: H05H 1/34, H01J 37/32

(54) **PLASMABESCHICHTUNGSANLAGE UND VERFAHREN ZUM BESCHICHTEN ODER BEHANDELN DER OBERFLÄCHE EINES SUBSTRATS**
PLASMA COATING ASSEMBLY AND METHOD FOR COATING OR TREATING THE SURFACE OF A SUBSTRATE
INSTALLATION DE REVÊTEMENT DE PLASMA ET PROCÉDÉ DE REVÊTEMENT OU DE TRAITEMENT DE LA SURFACE D'UN SUBSTRAT

(30) Priorität: 05.02.2009 EP 09152189
(43) Veröffentlichungstag der Anmeldung: 14.12.2011
(73) Patentinhaber: Oerlikon Metco AG, Wohlen, 5610 Wohlen (CH)
(72) Erfinder: GINDRAT, Malko, CH-5610 Wohlen (CH); GUITTIENNE, Philippe, CH-1092 Belmont-sur-Lausanne (CH); HOLLENSTEIN, Christoph, CH-1095 Lutry (CH)
(74) Vertreter: Intellectual Property Services GmbH
(86) Internationale Anmeldenummer: PCT/EP2010/050459
(87) Internationale Veröffentlichungsnummer: WO 2010/089175

(56) Entgegenhaltungen:
- EP-A- 0 706 308
- FR-A- 2 677 841
- US-A- 4 948 485

## Beschreibung

Die Erfindung betrifft eine Plasmabeschichtungsanlage und ein Verfahren zum Beschichten oder Behandeln der Oberfläche eines Substrats gemäss dem Oberbegriff des unabhängigen Anspruchs der jeweiligen Kategorie.

Die US 4,948,485 A beschreibt eine Plasmabeschichtungsanlage mit einem Plasmabrenner zur Erzeugung eines Plasmastrahls durch Erhitzung eines Prozessgases. Der Plasmabrenner weist eine Düse auf, durch die der Plasmastrahl aus dem Plasmabrenner austreten kann und sich entlang einer Längsachse erstrecken kann. Stromabwärts der Düse ist ein in Längrichtung kurzer Ring vorgesehen, durch den sich der Plasmastrahl erstreckt. Der Zweck des Rings wird dabei nicht weiter beschrieben.

Von den zahlreichen verschiedenen Prozessen des thermischen Spritzens mittels Plasmabeschichtungsanlagen werden einige im Vakuumbereich durchgeführt, das heisst bei einem Prozessdruck, der kleiner ist als der Luftdruck in der Umgebung. Solche Prozesse müssen natürlich in evakuierbaren Arbeitskammern durchgeführt werden. Je nach Prozess können dabei in der Arbeitskammer Drücke von nur einigen hundertstel Millibar oder sogar noch weniger notwendig sein.

Beim Plasmaspritzen ist es üblich, durch Erhitzung eines Prozessgases einen Plasmastrahl zu erzeugen, in den das für die Beschichtung benötigte Material meist in Pulverform oder auch in fluider Form, also als Gas oder Flüssigkeit, eingebracht wird. Insbesondere beim Einbringen von Gas oder Flüssigkeit ist es auch bekannt, das Plasmaspritzen als reaktiven Prozess also vergleichbar einem CVD (Chemical vapor deposition) Prozess durchzuführen. Dabei wird das in den heissen Plasmastrahl eingebrachte Fluid, beispielsweise durch das Aufbrechen von Bindungen oder das Zerlegen von Molekülen, so modifiziert, dass die für die Beschichtung gewünschte Substanz erst im Plasmastrahl entsteht. Ein Beispiel hierfür ist das Einbringen von Hexamethyldisiloxan (HMDSO) als reaktive Substanz, um auf dem Substrat, z. B. einem Wafer, eine Siliziumoxidschicht zu erzeugen.

Bei diesen Vakuumprozessen ist es ein bekanntes Problem, dass der Plasmastrahl, der sich durch die evakuierte Arbeitskammer bewegt, im Bereich der Düse des Plasmabrenners zu einer Sogwirkung führt. Wird für einen reaktiven Prozess ein Gas oder eine Flüssigkeit in den Plasmastrahl eingebracht, so können durch die Modifikation des Fluids im Plasmastrahl Pulverteilchen oder Partikel entstehen. Dies kann zur Folge haben, dass Partikel - insbesondere am Rand des Plasmastrahls - umgelenkt werden, sich wieder in Richtung der Düse zurück bewegen und dann durch die Sogwirkung wieder in den Plasmastrahl eingesaugt werden. Derartige "rezyklierte" Partikel oder Pulverteilchen, die nicht aufgeschmolzen oder ausreichend plastifiziert werden, führen in aller Regel zu ungewünschten Störungen in der auf dem Substrat generierten Beschichtung.

Dieses Problem tritt auch bei Prozessen auf, bei denen ein Pulver in den Plasmastrahl eingebracht wird. So können nicht oder nur teilweise aufgeschmolzene bzw. plastifizierte Pulverteilchen in gleicher Weise wie vorangehend beschrieben, in Richtung der Düse zurück bewegt und dann in den Plasmastrahl eingesaugt werden. Auch diese Pulverteilchen oder Partikel führen zu ungewünschten Verunreinigungen auf dem Substrat.

Diesem Problem will die Erfindung Abhilfe schaffen. Es ist daher eine Aufgabe der Erfindung eine Plasmabeschichtungsanlage und ein Verfahren zum Beschichten oder Behandeln der Oberfläche eines Substrats vorzuschlagen, bei welchen das unerwünschte Eindringen von Partikeln in den Plasmastrahl zumindest deutlich reduziert wird.

Die diese Aufgabe in apparativer und verfahrenstechnischer Hinsicht lösenden Gegenstände der Erfindung sind durch die unabhängigen Ansprüche der jeweiligen Kategorie gekennzeichnet.

Erfindungsgemäss wird also eine Plasmabeschichtungsanlage zum Beschichten oder Behandeln der Oberfläche eines Substrats vorgeschlagen mit einer Arbeitskammer, die evakuierbar ist und in welcher das Substrat platzierbar ist, und mit einem Plasmabrenner zur Erzeugung eines Plasmastrahls durch Erhitzung eines Prozessgases, wobei der Plasmabrenner eine Düse aufweist, durch welche der Plasmastrahl aus dem Plasmabrenner austreten und sich entlang einer Längsachse in der Arbeitskammer erstrecken kann, wobei stromabwärts der Düse in der Arbeitskammer eine mechanische Beschränkungsvorrichtung vorgesehen ist, welche sich entlang der Längsachse erstreckt und den Plasmastrahl gegen ein seitliches, unerwünschtes Eindringen von Partikeln schützt.

Diese Beschränkungsvorrichtung grenzt den heissen schnellen Plasmastrahl gegenüber dem kälteren, ruhigen, d.h. im wesentlichen strömungsfreien Vakuum ab und verhindert somit, dass in unerwünschter Weise Partikel aus dem Vakuumbereich von der Seite in den heissen Plasmastrahl eingesaugt werden. Mit "seitlich" bzw. "von der Seite" ist dabei schräg oder senkrecht zur Längsachse A gemeint.

Durch die Beschränkungsvorrichtung ist die Aufweitung des Plasmastrahls senkrecht zur Längsachse beschränkt.

Durch diese Beschränkungsvorrichtung wird der Plasmastrahl somit umgeben bzw. umschlossen, sodass von der Seite her keine Partikel mehr unerwünscht in den Plasmastrahl gelangen können.

Erfindungsgemäss ist ausserdem ein Substrathalter zum Halten eines Substrats vorgesehen, wobei sich die Beschränkungsvorrichtung über mindestens 80% vorzugsweise mindestens 90% der Entfernung zwischen der Düse und dem Substrathalter erstreckt. Durch diese Massnahme ist der Plasmastrahl im wesentlichen über seine gesamte Länge von der Düse des Plasmabrenners bis hin zum Substrat gegen Verunreinigungen geschützt.

Vorzugsweise ist die Beschränkungsvorrichtung unmittelbar stromabwärts der Düse des Plasmabrenners angeordnet, weil hier die Sogwirkung am stärksten und somit das Eindringen von Partikeln am wahrscheinlichsten ist.

Vorteilhafterweise ist die Beschränkungsvorrichtung als Rohr ausgestaltet, insbesondere als metallisches Rohr.

Gemäss einem bevorzugten Ausführungsbeispiel ist die Beschränkungsvorrichtung als zylindrisches Rohr ausgestaltet, dessen Durchmesser höchstens das zehnfache, insbesondere höchstens das fünffache des Durchmessers der Düse an ihrer Austrittsöffnung beträgt.

Zum Durchführen von reaktiven Prozessen ist bevorzugt ferner eine Injektionsvorrichtung vorgesehen, um ein reaktives Fluid in den Plasmastrahl zu injizieren.

Eine mögliche Ausgestaltung ist es, wenn die Injektionsvorrichtung eine ringförmige Injektionsdüse umfasst, welche in der Beschränkungsvorrichtung angeordnet ist.

Durch die Erfindung wird ferner ein Verfahren zum Beschichten oder Behandeln der Oberfläche eines Substrats mittels einer Plasmabeschichtungsanlage vorgeschlagen, bei welchem das Substrat in einer Arbeitskammer platziert wird, die Arbeitskammer auf einen Druck von weniger als ein bar evakuiert wird, mittels eines Plasmabrenners ein Plasmastrahl durch Erhitzung eines Prozessgases erzeugt wird, welcher durch eine Düse aus dem Plasmabrenner austritt und sich entlang einer Längsachse in der Arbeitskammer erstrecken kann, wobei der Plasmastrahl durch eine mechanische Beschränkungsvorrichtung, die sich entlang der Längsachse erstreckt, gegen ein seitliches, unerwünschtes Eindringen von Partikeln geschützt wird.

Die Aufweitung des Plasmastrahls stromabwärts der Düse wird in der Arbeitskammer senkrecht zur Längsachse durch die mechanische Beschränkungsvorrichtung beschränkt.

Zur Durchführung reaktiver Prozesse wird vorzugsweise mittels einer Injektionsvorrichtung ein reaktives Fluid in den Plasmastrahl injiziert.

Auch verfahrenstechnisch ist es eine bevorzugte Massnahme, wenn durch die Beschränkungsvorrichtung der Plasmastrahl über mindestens 80%, vorzugsweise mindestens 90% seiner Länge zwischen der Düse und dem Substrat geschützt wird.

Das erfindungsgemässe Verfahren eignet sich insbesondere für solche Prozesse, bei welchem der Prozessdruck in der Arbeitskammer beim Beschichten höchstens 100 mbar, vorzugsweise höchstens 50 mbar und speziell höchstens 30 mbar beträgt. Gerade bei niedrigen Prozessdrucken ist nämlich die Gefahr der unerwünschten Rezirkulation bzw. des unerwünschten Einsaugens von Partikeln aus dem Vakuumbereich in den Plasmastrahl besonders ausgeprägt. Solche Partikel, die z. B. als Moleküle, freie Radikale oder als sonstige sehr kleine Partikel - auch im Nanometerbereich - vorliegen können, haben bei niedrigen Prozessdrücken eine höhere freie Weglänge im Vakuum, sodass die Wahrscheinlichkeit zunimmt, dass deratike Partikel in den Plasmastrahl eindringen bzw. in diesen eingesaugt werden können. Bei atmosphärischem oder noch höherem Prozessdruck würden solche Partikel in der Regel sofort abgebremst sobald sie den Plasmastrahl seitlich verlassen.

Weitere vorteilhafte Massnahmen und Ausgestaltungen ergeben sich aus den abhängigen Ansprüchen.

Im Folgenden wird die Erfindung sowohl in apparativer als auch in verfahrenstechnischer Hinsicht anhand von Ausführungsbeispielen und anhand der Zeichnung näher erläutert. In der schematischen, nicht massstäblichen Zeichnung zeigen:
- Fig. 1: ein Ausführungsbeispiel einer Plasmabeschichtungsanlage gemäss der vorliegender Erfindung,
- Fig. 2: eine Ansicht der Beschränkungsvorrichtung aus Fig.1,
- Fig. 3: einen Schnitt durch die Beschränkungsvorrichtung entlang der Schnittlinie III - III in Fig. 2,
- Fig. 4: eine Aufsicht auf die Beschränkungsvorrichtung aus der Blickrichtung IV in Fig. 2, und
- Fig. 5: eine Variante für das Ausführungsbeispiel aus Fig. 1.

Im Folgenden wird die Erfindung anhand eines für die Praxis besonders relevanten Beispiels erläutert, nämlich anhand eines reaktiven Plasmaspritzprozesses. Dabei wird ein flüssiges oder ein gasförmiges Ausgangsmaterial in den Plasmastrahl eingebracht. Durch die hohe Energie des Plasmastrahls werden die Moleküle oder Bestandteile des fluiden Ausgangsmaterials modifiziert, beispielsweise durch Aufbrechen von Bindungen, Abspalten von Bestandteilen usw. wodurch die für die Beschichtung gewünschten Komponenten entstehen. Derartige Prozesse sind vom Prinzip her auch mit CVD-Prozessen vergleichbar, weshalb sie manchmal als reaktiver thermischer CVD-Prozess bezeichnet werden. Insbesondere geeignet für diese Art von Verfahren ist das sogenannte Low Pressure Plasma Spraying (LPPS) bzw. das Low Pressure Plasma Spraying - Thin Film-Verfahren (LPPS-TF).

Es versteht sich aber, dass die Erfindung keinesfalls auf diese reaktiven Plasmaspritzprozesse beschränkt ist. Sie eignet sich in sinngemäss gleicher Weise für alle Plasmaspritzprozesse die im Vakuum durchgeführt werden, also bei einem Prozessdruck, der kleiner ist als der Umgebungsluftdruck. Denn bei diesen Vakuum-Plasmaspritzprozessen tritt das eingangs geschilderte Problem der Rezirkulation von Pulverteilchen und Partikeln auf, dass durch die Erfindung gelöst oder zumindest reduziert werden soll Insbesondere ist die Erfindung auch für solche Vakuum-Plasmaspritzprozesse geeignet, bei denen ein pulverförmiges Ausgangsmaterial in den Plasmastrahl eingebracht wird.

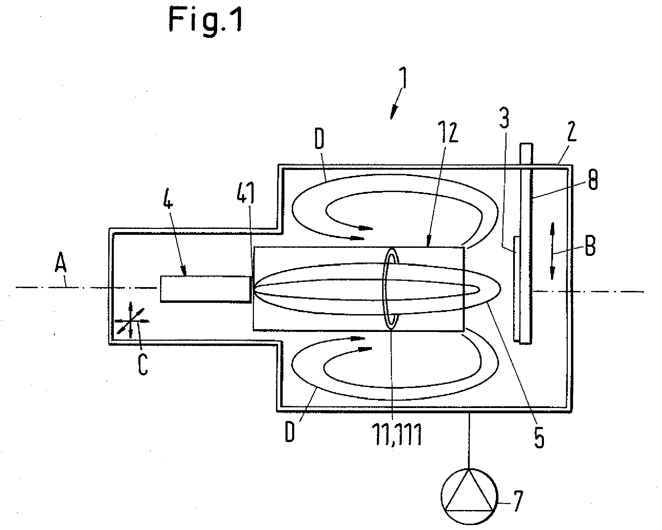

Fig. 1 zeigt in einer schematischen Darstellung ein Ausführungsbeispiel einer erfindungsgemässen Plasmabeschichtungsanlage, die gesamthaft mit dem Bezugszeichen 1 versehen ist. Die Plasmabeschichtungsanlage 1 umfasst eine Arbeitskammer 2 mit einem Plasmabrenner 4 zur Erzeugung eines Plasmastrahls 5 durch Erhitzung eines Prozessgases. Der Plasmastrahl 5 tritt durch eine Düse 41 des Plasmabrenners 4 aus und breitet sich im Betriebszustand entlang der Längsachse A aus. Ferner ist eine gesteuerte Pumpvorrichtung 7 vorgesehen, die mit der Arbeitskammer 2 verbunden ist, um den Prozessdruck in der Arbeitskammer 2 einzustellen. In der Arbeitskammer 2 ist ein Substrathalter 8 zum Halten eines Substrats 3 vorgesehen, der mindestens in einer Richtung senkrecht zur Längsachse A bewegbar ausgestaltet sein kann, wie dies der Doppelpfeil B in Fig. 1 andeutet. Dadurch lässt sich das Substrat 3 senkrecht zur Längsachse A bewegen sodass sukzessive verschiedene Bereiche des Substrats 3 dem Plasmastrahl 5 ausgesetzt werden können. Zusätzlich oder alternativ kann der Substrathalter 8 so ausgestaltet sein, dass das Substrat falls erforderlich während der Behandlung oder Beschichtung gedreht werden kann.

Vorzugsweise ist auch der Plasmabrenner 4 auf einer Zweiachsen- oder Dreiachsen-Verschiebehalterung angebracht, wie das die Pfeile C in Fig. 1 andeuten, sodass die relative Position des Plasmabrenners 4 und damit der Düse 41 zum Substrat 3 in zwei oder drei Dimensionen veränderbar ist. Insbesondere kann der Abstand vom der Düse 41 zum Substrat 3 verändert werden.

Bezüglich weiterer Einzelheiten der Ausgestaltung der Plasmaspritzanlage 1 und insbesondere der Prozessparameterbereiche und der Injektion in den Plasmastrahl 5 sei hier auf die europäische Patentanmeldung Nr. 08154091.6 der gleichen Anmelderin verwiesen.

Das flüssige bzw. gasförmige Ausgangsmaterial, das beim reaktiven Plasmaspritzen in den Plasmastrahl 5 injiziert wird, kann an verschiedenen Stellen in den Plasmastrahl 5 eingebracht werden, beispielsweise in der Düse 41 oder stomaufwärts unmittelbar vor der Düse 41 oder zusammen mit dem Prozessgas in axialer Richtung, also in Richtung der Längsachse A oder auch durch eine Injektionsvorrichtung 11, die stromabwärts weiter entfernt von der Düse angeordnet ist. Natürlich sind auch Kombinationen dieser Varianten möglich. Insbesondere bezüglich der Einbringung von fluiden Medien in den Plasmastrahl 5 wird auf die EP-A-1 895 818 der gleichen Anmelderin sowie auf die bereits zitierte europäische Patentanmeldung Nr. 08154091.6 der gleichen Anmelderin verwiesen.

Erfindungsgemäss ist in der Arbeitskammer 2 eine mechanische Beschränkungsvorrichtung 12 vorgesehen, welche sich entlang der Längsachse A erstreckt und den Plasmastrahl 5 gegen ein seitliches unerwünschtes Eindringen von Partikeln schützt. Zudem wird hierdurch die Aufweitung des Plasmastrahls senkrecht zur Längsachse A beschränkt, der heisse Plasmastrahl wird gegenüber dem kälteren Vakuumbereich abgegrenzt. Im vorliegenden Ausführungsbeispiel ist die Beschränkungsvorrichtung als zylindrisches Rohr ausgestaltet, dass sich in Richtung der Längsachse A erstreckt und koaxial zur Längsachse A verläuft. Vorzugsweise ist die Beschränkungsvorrichtung 12 aus einem metallischen Material, insbesondere einem Metall oder einer Legierung, gefertigt.

Durch die Beschränkungsvorrichtung wird die Rezirkulation von Partikel oder Pulverteilchen effizient unterbunden, so wie dies die Pfeile D in der Fig. 1 andeuten. Es wird somit verhindert, dass die durch die Sogwirkung des Plasmastrahls 5 in Richtung der Düse 41 zurück bewegten Partikel wieder seitlich - also schräg oder senkrecht zur Längsachse A - in den Plasmastrahl eindringen können. Durch diese Massnahme lässt sich die Qualität der erzeugten Beschichtung auf dem Substrat deutlich steigern.

Vorzugsweise beginnt die Beschränkungsvorrichtung 12 unmittelnbar stromabwärts der Düse 41. Je nach Bauart kann sie auch an die Düse 41 angrenzen. Ferner ist es bevorzugt, wenn sich die Beschränkungsvorrichtung 12 über mindestens 80%, vorzugsweise mindestens 90% der Entfernung zwischen der Düse 41 und dem Substrat 3 erstreckt, denn auf diese Weise ist der Plasmastrahl im wesentlichen über seine gesamte Länge zwischen der Düse 41 und dem Substrat 3 geschützt. Es können von der Seite - also schräg oder senkrecht zur Längsachse A keine Partikel mehr in unerwünschter Weise aus dem Vakuumbereich in den Plasmastrahl 5 eindringen.

Dieser Schutz des Plasmastrahls 5 ist auch dann besonders wichtig, wenn - wie im hier beschriebenen Ausführungsbeispiel - die Injektionsvorrichtung 11 weiter stromabwärts der Düse 41 vorgesehen ist.

Die jeweiligen Abmessungen der Beschränkungsvorrichtung 12 hängen vom spezifischen Anwendungsfall ab und können für diesen optimiert werden. Die Beschränkungsvorrichtung 12 sollte vorzugsweise so bemessen sein, dass sie den Plasmastrahl bezüglich der lateralen Richtung - also senkrecht zur Längsachse A - vollkommen umschliesst, das heisst im Bereich der Beschränkungsvorrichtung 12 sollte der Plasmastrahl im wesentlichen vollkommen innerhalb der Beschränkungsvorrichtung 12 verlaufen. Einerseits darf der Durchmesser der Beschränksvorrichtung 12 bzw. ihre lichte Weite senkrecht zu Längsachse A nicht zu klein sein weil dann der thermische Energieübertrag vom Plasmastrahl 5 auf die Beschränkungsvorrichtung 12 zu stark ist und letztere beschädigen kann. Andererseits darf der Durchmesser der Beschränksvorrichtung 12 bzw. ihre lichte Weite senkrecht zu Längsachse A nicht so gross sein, dass die Beschränkungsvorrichtung 12 keine wirkliche Beschränkung mehr für die laterale Ausdehnung (senkrecht zur Längsachse A) des Plasmastrahls mehr darstellt, denn dann würde beispielsweise die Gefahr bestehen, dass es innerhalb der Beschränkungsvorrichtung zu ungewünschter Rezirkulation von Partikeln kommen kann.

Die Beschränkungsvorrichtung ist nicht wesentlich für die Formung oder die Führung des Plasmastrahls, denn die Form oder Gestalt des Plasmastrahls ist im Wesentlichen durch die Druck- und Energieverhältnisse sowie die Gasflüsse bestimmt. Die Beschränkungsvorrichtung grenzt den heissen Plasmastrahl gegen das kühlere Vakuum ab.

Der geeignete Durchmesser bzw. die lichte Weite der Beschränkungsvorrichtung hängt somit vom Plasmastrahl und insbesondere von seiner lateralen Ausdehnung, die er ohne Begrenzungsvorrichtung hätte, ab. So wird beispielsweise die laterale Ausdehnung des Plasmastrahls grösser, je niedriger der Prozessdruck in der Arbeitskammer ist, und je höher die Plasmaleistung ist. Dem Fachmann ist es möglich, die Dimensionen der Beschränkungsvorrichtung an den jeweiligen Anwendungsfall anzupassen.

In der Praxis sind bei zylindrischen rohrförmigen Beschränkungsvorrichtungen 12 insbesondere Durchmesser von mindestens 5 bis 10cm und von bis zu 50 cm geeignet.

Natürlich ist es nicht notwendig, dass die Beschränkungsvorrichtung 12 als zylindrisches Rohr ausgestaltet ist, auch andere Querschnittsformen wie viereckig, mehreckig. oval oder anders gekrümmt sind möglich. Auch kann es vorteilhaft sein, wenn die Beschränkungsvorrichtung 12 ihre Querschnittsfläche in Richtung der Längsachse A verändert.

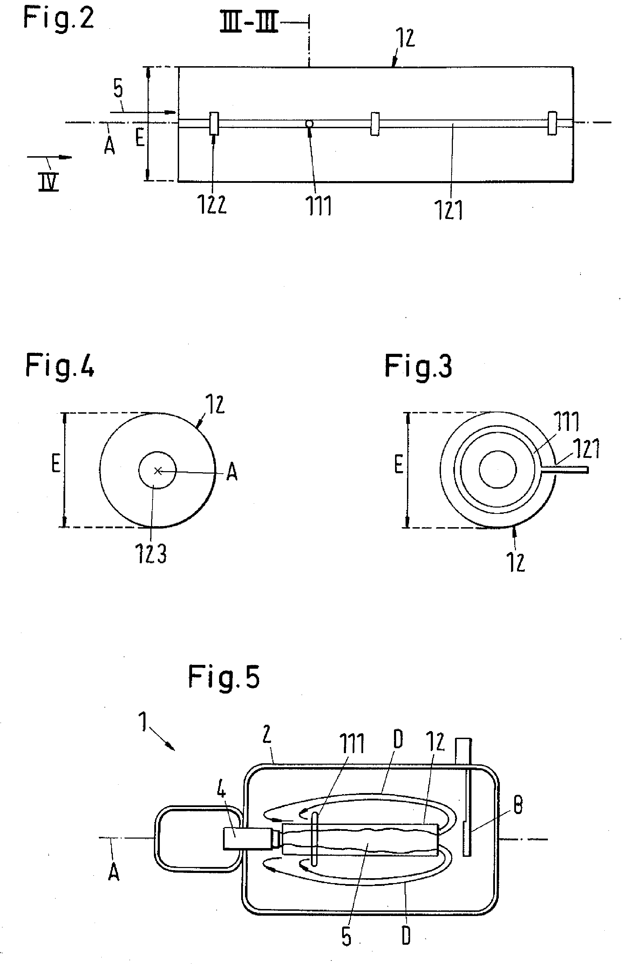

Die Fig. 2 bis 4 zeigen die Beschränkungsvorrichtung 12 genauer. Fig. 2 zeigt eine seitliche Ansicht der Beschränkungsvorrichtung 12 aus Fig. 1. Die Beschränkungsvorrichtung 12 ist als metallisches, zylindrisches Rohr 12 ausgestaltet, das sich in Richtung der Längsachse A erstreckt und einen Durchmesser E aufweist. Das Rohr ist seitlich mit einem Schlitz 121 versehen, der eine Beobachtung des Plasmastrahls 5 während des Betriebs erlaubt und beispielsweise auch der Aufnahme von Sensoren dienen kann. Zur Stabilisierung sind Halteelemente 122 vorgesehen.

Der Schlitz 121 dient ferner zur Aufnahme einer ringförmigen Injektionsdüse 111 die Teil der Injektionsvorrichtung 11 ist, mit welcher das reaktive Fluid in den Plasmastrahl einbringbar ist. Bezüglich dieser Ringdüse 111 sei wiederum auf die bereits zitierte europäische Patentanmeldung Nr. 08154091.6 der gleichen Anmelderin verwiesen.

Fig. 3 zeigt einen Schnitt durch die Beschränkungsvorrichtung entlang der Schnittlinie 111-111 in Fig. 2. Hier ist insbesondere auch die ringförmige Injektionsdüse 111 zu erkennen.

Fig. 4 zeigt eine Aufsicht auf die Beschränkungsvorrichtung 12 aus der Blickrichtung IV in Fig. 2 und zeigt eine Eintrittsöffnung 123 der Beschränkungsvorrichtung 12.

Es versteht sich, dass bei solchen Vakuum-Prozessen, bei denen kein Fluid in den Plasmastrahl 5 eingebracht wird sondern beispielsweise ein Pulver, auf die Injektionsvorrichtung 11 bzw. die ringförmige Injektionsdüse 111 verzichtet werden kann.

Fig. 5 zeigt schliesslich noch in einer zu Fig. 1 analogen Darstellung eine Variante für das Ausführungsbeispiel der Plasmabeschichtungsanlage 1. Im Unterschied zu Fig. 1 ist bei dieser Variante die ringförmige Injektionsdüse ausserhalb der Beschränkungsvorrichtung 12 vorgesehen, sodass sie die Beschränkungsvorrichtung 12 umschliesst. Es versteht sich, dass mindestens eine spalt oder düsenförmige Verbindungsöffnung vorgesehen ist, durch welche das Fluid in den Plasmastrahl einbringbar ist.

Bei einem Ausführungsbeispiel des erfindungsgemässen Verfahrens wird die Herstellung und Anwendung einer dünnen SiOₓ Schicht mittels eines reaktiven thermischen Niederdruckplasmas näher erläutert. Zur Herstellung kann ein handelsüblicher Plasmabrenner mit einer Leistung zum thermischen Plasmaspritzen verwendet werden, beispielsweise ein Plasmabrenner mit drei Kathoden und kaskadierter Anode, der mit einer Wasserkühlung ausgestattet ist. Insbesondere ist hierfür der Plasmabrenner geeignet, der von der Anmelderin unter dem Namen TriplexPro vertrieben wird. Als Plasmagas kann Argon, eine Mischung von Argon und Wasserstoff oder Argon und Helium verwendet werden, und die reaktive Komponente, die in den Plasmastrahl injiziert wird, kann zum Beispiel aus einer Mischung von gasförmigem Hexamethyldisiloxan (HMDSO) mit Sauerstoff bestehen. Typisch beträgt der Sauerstoffanteil in der HMDSO/O₂-Mischung rund 2 % bis 3 % bezogen auf den Gasfluss. Um eine hohe Gasausbeute zu erzielen, wird die reaktive Komponente mittels der ringförmigen Injektonsdüse 111 in den Plasmastrahl 5 injiziert. Der Abstand zwischen dem Substrat 3 und der Injektionsdüse 111 beträgt etwa 77 cm. Der Abstand der Düse 41 des Plasmabrenners 4 vom Substrat beträgt etwa 1 m, der Prozessdruck in der Arbeitskammer 0.2 mbar bis 1 mbar, insbesondere etwa 0.5 mbar und die dem Plasmabrenner zugeführte Leistung 8 kW bis 16 kW. Der Sauerstofffluss beträgt etwa 3.4 Liter pro Minute.

Auf diese Weise können hochwertige SiOₓ-Schichten von beispielsweise 2 µm Dicke aber auch mit einer Dicke kleiner oder gleich 10 bis 20 µm aufgebracht werden. Die Abscheidrate auf einem 30 cm x 30 cm grossen Substrat liegt typisch bei 10 nm/s oder höher, wobei bezogen auf das zugeführte HMDSO-Gas eine hohe Gasausbeute erreicht werden kann. Die SiOₓ-Schichten zeichnen sich durch eine hohe Reinheit aus. Insbesondere das ohne Beschränkungsvorrichtung 12 oft erkennbare milchige Aussehen der Beschichtung auf denm Substrat 3 ist nicht mehr zu sehen bzw. deutlich reduziert.

## Patentansprüche

1. Plasmabeschichtungsanlage zum Beschichten oder Behandeln der Oberfläche eines Substrats (3) mit einer Arbeitskammer (2), die evakuierbar ist und in welcher das Substrat (3) platzierbar ist, und mit einem Plasmabrenner (4) zur Erzeugung eines Plasmastrahls (5) durch Erhitzung eines Prozessgases, wobei der Plasmabrenner (4) eine Düse (41) aufweist, durch welche der Plasmastrahl (5) aus dem Plasmabrenner (4) austreten und sich entlang einer Längsachse (A) in der Arbeitskammer (2) erstrecken kann, wobei stromabwärts der Düse (41) in der Arbeitskammer (2) eine mechanische Beschränkungsvorrichtung (12) vorgesehen ist, welche sich entlang der Längsachse (A) erstreckt und den Plasmastrahl (5) gegen ein seitliches, unerwünschtes Eindringen von Partikeln schützt, **gekennzeichnet, durch** einen Substrathalter (8) zum Halten des Substrats (3), wobei sich die Beschränkungsvorrichtung (12) über mindestens 80% vorzugsweise mindestens 90% der Entfernung zwischen der Düse (41) und dem Substrathalter (8) erstreckt.

2. Plasmabeschichtungsanlage nach Anspruch 1, wobei die Beschränkungsvorrichtung (12) unmittelbar stromabwärts der Düse (41) des Plasmabrenners (4) angeordnet ist.

3. Plasmabeschichtungsanlage nach Anspruch 1 oder 2, wobei die Beschränkungsvorrichtung (12) als Rohr ausgestaltet ist, insbesondere als metallisches Rohr.

4. Plasmabeschichtungsanlage nach einem der vorangehenden Ansprüche, wobei die Beschränkungsvorrichtung (12) als zylindrisches Rohr ausgestaltet ist, dessen Durchmesser (E) höchstens das zehnfache, insbesondere höchstens das fünffache des Durchmessers der Düse (41) an ihrer Austrittsöffnung beträgt.

5. Plasmabeschichtungsanlage nach einem der vorangehenden Ansprüche, wobei ferner eine Injektionsvorrichtung (11) vorgesehen ist, um ein reaktives Fluid in den Plasmastrahl (5) zu injizieren.

6. Plasmabeschichtungsanlage nach Anspruch 5 wobei die Injektionsvorrichtung (11) eine ringförmige Injektionsdüse (111) umfasst, welche in der Beschränkungsvorrichtung (12) angeordnet ist.

7. Verfahren zum Beschichten oder Behandeln der Oberfläche eines Substrats mittels einer Plasmabeschichtungsanlage, bei welchem das Substrat (3) in einer Arbeitskammer (2) platziert wird, die Arbeitskammer (2) auf einen Druck von weniger als ein bar evakuiert wird, mittels eines Plasmabrenners (4) ein Plasmastrahl (5) durch Erhitzung eines Prozessgases erzeugt wird, welcher durch eine Düse (41) aus dem Plasmabrenner (4) austritt, sich entlang einer Längsachse (A) in der Arbeitskammer (2) erstrecken kann und der Plasmastrahl (5) durch eine mechanische Beschränkungsvorrichtung (12), die sich entlang der Längsachse (A) erstreckt, gegen ein seitliches, unerwünschtes Eindringen von Partikeln geschützt wird,
**dadurch gekennzeichnet, dass**
durch die Beschränkungsvorrichtung (12) der Plasmastrahl (5) über mindestens 80%, vorzugsweise mindestens 90% seiner Länge zwischen der Düse (41) und dem Substrat (3) geschützt wird.

8. Verfahren nach Anspruch 7, wobei mittels einer Injektionsvorrichtung (11) ein reaktives Fluid in den Plasmastrahl injiziert wird.

9. Verfahren nach einem der Ansprüche 7 oder 8, bei welchem der Prozessdruck in der Arbeitskammer (2) beim Beschichten höchstens 100 mbar, vorzugsweise höchstens 50 mbar und speziell höchstens 30 mbar beträgt.

## Claims

1. A plasma coating plant for coating or treating the surface of a substrate (3), having a work chamber (2) which can be evacuated and into which the substrate (3) can be placed, and having a plasma torch (4) for generating a plasma jet (5) by heating a process gas, wherein the plasma torch (4) has a nozzle (41) through which the plasma jet (5) can exit the plasma torch (4) and can extend along a longitudinal axis (A) into the work chamber (2), wherein a mechanical limiting apparatus (12) is provided downstream of the nozzle (41) in the work chamber (2), which mechanical limiting apparatus extends along the longitudinal axis (A) and protects the plasma jet (5) against an unwanted lateral intrusion of particles,
**characterized in that** a substrate holder (8) for holding the substrate (3), wherein the limiting apparatus (12) extends over at least 80 % of the distance between the nozzle (41) and the substrate holder (8), preferably over at least 90 % of the distance.

2. A plasma coating plant in accordance with claim 1, wherein the limiting apparatus (12) is arranged directly downstream of the nozzle (41) of the plasma torch (4).

3. A plasma coating plant in accordance with claim 1 or claim 2, wherein the limiting apparatus (12) is configured as a tube, in particular as a metallic tube.

4. A plasma coating plant in accordance with any one of the preceding claims, wherein limiting apparatus (12) is configured as a cylindrical tube whose diameter (E) is at most the ten-fold of the diameter of the nozzle (41) at its outlet opening, in particular is at most the five-fold of the diameter of the nozzle.

5. A plasma coating plant in accordance with any one of the preceding claims, wherein an injection apparatus (11) is further provided to inject a reactive fluid into the plasma jet (5).

6. A plasma coating plant in accordance with claim 5, wherein the injection apparatus (11) includes a ring-shaped injection nozzle (111) which is arranged in the limiting apparatus (12).

7. A method of coating or treating the surface of a substrate (3) by means of a plasma coating plant in which the substrate (3) is placed into a work chamber (2), the work chamber is evacuated to a pressure of less than 1 bar, a plasma jet (5) is generated by means of a plasma torch (4) by heating a process gas, which plasma jet exits the plasma torch (4) through a nozzle (41), can extend along a longitudinal axis (A) in the work chamber (2), and the plasma jet (5) is protected against an unwanted lateral intrusion of particles by a mechanical limiting apparatus (12) which extends along the longitudinal axis (A) **characterized in that** the plasma jet (5) is protected by the limiting apparatus (12) over at least 80 % of its length between the nozzle (41) and the substrate (3), preferably over 90 % of its length.

8. A method in accordance with claim 7, wherein a reactive fluid is injected into the plasma jet by means of an injection apparatus (11).

9. A method in accordance with any one of the claims 7 or 8, in which the process pressure in the work chamber (2) is at most 100 mbar on coating, preferably at most 50 mbar and especially at most 30 mbar.

## Revendications

1. Installation de revêtement au plasma pour revêtir ou traiter la surface d'un substrat (3), ayant une chambre de travail (2) qui peut être évacuée et dans laquelle le substrat (3) peut être placé, et ayant une torche à plasma (4) pour produire un jet de plasma (5) par chauffage d'un gaz de traitement, dans laquelle la torche à plasma (4) présente une buse (41), à travers laquelle le jet de plasma (5) peut sortir de la torche à plasma (4) et s'étendre le long d'un axe longitudinal (A) dans la chambre du travail (2), dans laquelle un dispositif de limitation mécanique (12) est prévue en aval de la buse (41) dans la chambre du travail (2), qui s'étend le long de l'axe longitudinal (A) et protège le jet de plasma (5) à l'encontre d'une entrée latérale indésirable de particules, **caractérisée par** un support de substrat (8) pour supporter le substrat (3), dans laquelle le dispositif de limitation (12) s'étend sur au moins 80 %, de préférence sur au moins 90 % de la distance entre la buse (41) et le support de substrat (8).

2. Installation de revêtement au plasma selon la revendication 1, dans laquelle le dispositif de limitation (12) est agencé directement en aval de la buse (41) de la torche à plasma (4).

3. Installation de revêtement au plasma selon la revendication 1 ou 2, dans laquelle le dispositif de limitation (12) est configuré sous la forme d'un tube, en particulier sous la forme d'un tube métallique.

4. Installation de revêtement au plasma selon l'une quelconque des revendications précédentes, dans laquelle le dispositif de limitation (12) est configuré sous la forme d'un tube cylindrique dont le diamètre (E) équivaut au plus à dix fois, en particulier au plus à cinq fois le diamètre de la buse (41) à son orifice de sortie.

5. Installation de revêtement au plasma selon l'une quelconque des revendications précédentes, dans laquelle de plus un dispositif d'injection (11) est prévu, pour injecter un fluide réactif dans le jet de plasma (5).

6. Installation de revêtement au plasma selon la revendication 5, dans laquelle le dispositif d'injection (11) présente une buse d'injection (111) de forme annulaire, qui est agencée dans le dispositif de limitation (12).

7. Procédé pour revêtir ou traiter la surface d'un substrat par l'intermédiaire d'une installation de revêtement au plasma, dans lequel le substrat (3) va être placé dans une chambre du travail (2), la chambre de travail (2) va être évacuée à une pression inférieure à un bar, un jet de plasma (5) va être produit par l'intermédiaire d'une torche à plasma (4) par chauffage d'un gaz de traitement, qui peut sortir de la torche à plasma (4) à travers une buse (41) et peut s'étendre le long d'un axe longitudinal (A) dans la chambre du travail (2), et le jet de plasma (5) va être protégé par un dispositif de limitation mécanique (12) qui s'étend le long de l'axe longitudinal (A) à l'encontre d'une entrée latérale indésirable de particules, **caractérisé en ce que** le dispositif de limitation (12) va protéger le jet de plasma (5) sur au moins 80 %, de préférence sur au moins 90% de sa longueur entre la buse (41) et le support de substrat (3).

8. Procédé selon la revendication 7, dans lequel un fluide réactif va être injecté dans le jet de plasma au moyen d'un dispositif d'injection (11).

9. Procédé selon la revendication 7 ou 8, par l'intermédiaire duquel la pression de traitement dans la chambre du travail (2) lors d'une application en revêtement est au plus de 100 mbar, de préférence au plus de 50 mbar, et spécialement au plus de 30 mbar.
